# Europäisches Patentamt

## European Patent Office

## Office européen des brevets

(19)

(11) Veröffentlichungsnummer: **0 177 890**
**A2**

(12) **EUROPÄISCHE PATENTANMELDUNG**

(21) Anmeldenummer: **85112491.7**

(22) Anmeldetag: **03.10.85**

(51) Int. Cl.⁴: **G 03 F 7/26**

(30) Priorität: **11.10.84 DE 3437329**

(43) Veröffentlichungstag der Anmeldung: **16.04.86**
**Patentblatt 86/16**

(84) Benannte Vertragsstaaten: **AT BE DE FR GB IT NL SE**

(71) Anmelder: **HOECHST AKTIENGESELLSCHAFT,**
**Postfach 80 03 20, D-6230 Frankfurt am Main 80 (DE)**

(72) Erfinder: **Heist, Hans, Am Hohen Stein 4,**
**D-6200 Wiesbaden-Biebrich (DE)**
Erfinder: **Töpfer, Dieter, Mühlstrasse 5,**
**D-6209 Heidenrod 3 (DE)**
Erfinder: **Britzke, Sylvia, Eintrachtstrasse 13,**
**D-6200 Wiesbaden (DE)**

(54) **Vorrichtung zum Behandeln von Druckplatten mit einer Flüssigkeit.**

(57) Die Vorrichtung umfaßt eine Staubadwanne 11, bestehend aus einem Boden, zwei seitlichen Begrenzungswänden und je einer eingangs- und ausgangsseitig angeordneten Staubadrakel 5, 6. Der Boden trägt einen Plattenführungstisch 12, den eine rechteckförmige Staurinne 23 umgibt, die mit dem Boden integriert ist. Von der Staurinne 23 führen Zufuhrstutzen 17a, 17b, die lösbar in Aufnahmerohren 18a, 18b eingesteckt sind, zu einer T-förmig verzweigten Zufuhrleitung 14, die über eine Pumpe 15 und eine Leitung 25 mit einem Tank 16 als Vorratsbehälter für die Flüssigkeit verbunden ist. Die Aufnahmerohre 18a, 18b sind durch einen schrägen Boden 24 einer Auffangwanne 21, die die Staubadwanne 11 umgibt, geführt und mit dem Boden 24 fest verbunden. Oberhalb der Zutrittsöffnungen der Zufuhrstutzen sind in der Staurinne 23 Prallbleche 13a, 13b angeordnet. Die Flüssigkeit fließt in die Staubadwanne 11 durch die Leitungen 14, 25 und die Pumpe 15 ein und fließt auf dem gleichen Weg auch wieder ab.

EP 0 177 890 A2

HOECHST AKTIENGESELLSCHAFT
KALLE Niederlassung der Hoechst AG

84/K 080                    - 1 -          1. Oktober 1985
                                           WLK-DI.Z.-is

Vorrichtung zum Behandeln von Druckplatten mit einer
Flüssigkeit

Die Erfindung betrifft eine Vorrichtung zum Behandeln von Druckplatten mit einer Flüssigkeit, in der die Druckplatten horizontal durch eine Staubadwanne, bestehend aus einem Boden, zwei seitlichen Begrenzungswänden und je einem eingangs- und ausgangsseitig angeordneten Stauelement, hindurchgeführt werden.

Aus dem deutschen Gebrauchsmuster 71 41 280 ist eine Vorrichtung zur Behandlung von Druckplatten mit einem oder mehreren, die Behandlungsflüssigkeiten enthaltenden Bädern bekannt, durch die und über deren Boden die Druckplatten mit Förderwalzen hindurchgeleitet werden. Im einzelnen sind die Bäder durch den ebenen horizontalen Boden, einlauf- und auslaufseitige Staubürsten und seitliche Begrenzungswände aufgestaut. Während zur Begrenzung des Spülwasserbades normalerweise eine Staubürste mit nur einer Borstenreihe ausreichend ist, werden zur Begrenzung des Entwicklerbades die Staubürsten mit in Plattendurchlaufrichtung hintereinanderliegenden Borstenreihen versehen. Um die Verluste an Entwicklerflüssigkeit so klein wie möglich zu halten, wird auslaufseitig in Plattendurchlaufrichtung hinter der Staubürste noch ein Gummiabstreifer angeordnet. Zum Transport der Druckplatten durch das Bad dient ein erstes Förderwalzenpaar vor den Staubürsten und ein zweites Förderwalzenpaar hinter den Staubürsten.

HOECHST AKTIENGESELLSCHAFT
KALLE Niederlassung der Hoechst AG

- 2 -

In der DE-OS 24 61 120 ist eine Vorrichtung zur Behandlung bogenförmigen Materials beschrieben, die eine Vorweichkammer mit einer oberen und einer unteren Leitplatte aufweist. Die Vorweichkammer kann an den Seiten offen oder geschlossen sein. Zur Zufuhr der Entwicklerlösung in die Vorweichkammer dienen zwei Leitungen, die senkrecht zur Transportrichtung der Druckplatten angeordnet und an die Vorkammer angeschlossen sind, so daß die zugeführte Behandlungsflüssigkeit die gesamte Breite des zugeführten bogenförmigen Materials überdeckt. Das in die Vorweichkammer eingeführte Material wird zwischen den Leitplatten mit Entwicklerlösung überflutet, die durch die Entwicklerzuführleitungen zugeführt wird. Dabei treten in dem Entwicklerbad Turbulenzen auf, und da die Oberflächen der Druckplatte direkt mit dem einströmenden Entwickler in Berührung kommen, wirken sich die Turbulenzen auf die zu entwickelnden Oberflächen bei empfindlichen Druckplatten, insbesondere Positivdruckplatten, insofern nachteilig aus, als sich eine wolkige Aufentwicklung ergeben kann. Die wolkige Aufentwicklung wird auch durch nachfolgende Bürstvorgänge mit rotierenden Bürstenwalzen nicht mehr beseitigt. In einer Abwandlung dieser Entwicklungsvorrichtung ist es bekannt, die Entwicklerflüssigkeit durch Entwicklersprühdüsen auf die durch die Vorrichtung transportierten Druckplatten zu sprühen. Bei dem Entwicklerantrag mit Sprührohren oder Sprühdüsen ergibt sich jedoch bei besonders empfindlichen Druckplatten, insbesondere Positivdruckplatten, eine mehr oder weniger stark streifige Aufentwicklung.

HOECHST  AKTIENGESELLSCHAFT
KALLE  Niederlassung der Hoechst AG

- 3 -

Aus der DE-AS 22 50 278 ist eine Vorrichtung zur Behandlung von Druckplatten mit einer Flüssigkeit bekannt, die aus einem feststehenden Unterteil und einem
gegenüber diesem um eine waagerechte Achse kippbaren
Oberteil besteht. In dem feststehenden Unterteil sind
die unteren Walzen von Walzenpaaren angeordnet, während der kippbare Oberteil die oberen Walzen der Walzenpaare trägt.

Die DE-OS 22 38 414 betrifft ein Gerät zur gleichzeitigen Entwicklung einander gegenüberliegender Oberflächen von Flachdruckplatten, mit einer Vorschubeinrichtung zum Transport der Flachdruckplatte durch eine
Entwicklungsstation, die in einem Abstand zueinander
angeordnet einen oberen und unteren Boden aufweist.
Zwischen dem oberen und unteren Boden sind, eine Entwicklungskammer begrenzende Seitenwände in Abstand zueinander so angeordnet, daß die Entwicklungskammer
längs der Bewegungsbahn der Flachdruckplatte durch das
Gerät ausgerichtet ist. An einem Eintrittsende der
Entwicklungskammer bilden flexible Membranen eine
flüssigkeitsdichte Abdichtung und am Austrittsende ist
die Kammer mit einer, den Flüssigkeitsfluß einschränkenden Drossel versehen. Die Entwicklerflüssigkeit
wird unter gleichförmigem Druck von oben und unten zum
Füllen der Entwicklerkammer so eingepumpt, daß die
Oberflächen der Flachdruckplatte direkt mit dem einströmenden Entwickler in Berührung kommen, so daß auf
den zu entwickelnden Oberflächen der Druckplatte Turbulenzen entstehen, die bei empfindlichen Positiv-

HOECHST AKTIENGESELLSCHAFT
KALLE Niederlassung der Hoechst AG

- 4 -

druckplatten eine wolkige Aufentwicklung ergeben können.

Das deutsche Gebrauchsmuster 78 16 229 betrifft eine
Vorrichtung zur Behandlung von Positivdruckplatten mit
einer Flüssigkeit, die einen, die Behandlungsflüssigkeit als Bad enthaltenden Behälter aus einem Boden,
zwei seitlichen Begrenzungswänden und mindestens je
einem eingangs- und ausgangsseitig angeordneten Stauelement enthält. Über den Boden des Behälters werden
die Druckplatten horizontal durch die Behandlungsflüssigkeit hindurchtransportiert. Die Behandlungsflüssigkeit wird in den Behälter über ein Sprührohr eingebracht und zwischen dem Sprührohr und dem Boden ist
ein Leitblech angeordnet, das ein direktes Aufsprühen
der Entwicklerflüssigkeit auf die zu entwickelnde
Oberfläche der Druckplatte verhindert und somit die
Gefahr einer streifigen Aufentwicklung der Druckplatte
verringert.

Im Stand der Technik ist es im allgemeinen erforderlich, wenn die Bearbeitungsflüssigkeit mittels Sprührohren in das Bearbeitungsbad eingespeist wird, einen
bestimmten konstruktiven Aufwand zu betreiben, wie
beispielsweise den Einbau von Leitblechen zwischen den
Sprühdüsen und dem Flüssigkeitsbad, um Turbulenzen mit
den für die Entwicklung von Druckplatten nachteiligen
Folgen zu vermeiden. Dadurch werden dann auch Wartungs- und Reinigungsarbeiten umfangreicher, da solche
Teile, wie beispielsweise Leitbleche, ausgebaut wer-

HOECHST AKTIENGESELLSCHAFT
KALLE  Niederlassung der Hoechst AG

- 5 -

den müssen, um an die unteren Walzen von Transportwalzenpaaren für die Druckplatten herankommen zu können.

Aufgabe der Erfindung ist es, eine Vorrichtung zum Behandeln von Druckplatten der eingangs beschriebenen
Art so weiterzuentwickeln, daß sie ohne Sprührohre
arbeitet, der Aufwand für ihre Reinigung gering ist
und alle zu reinigenden Teile der Vorrichtung ohne
Werkzeug ausgebaut werden können.

Diese Aufgabe wird durch eine Vorrichtung nach den
Merkmalen des Oberbegriffs des Anspruchs 1 in der
Weise gelöst, daß der Boden der Staubadwanne einen
Plattenführungstisch und eine um den Plattenführungstisch umlaufende, mit diesem integrierte Staurinne
umfaßt, daß in der Staurinne eingangs- und ausgangsseitig je ein Zufuhrstutzen für die Flüssigkeit angeordnet ist und daß die beiden Zufuhrstutzen lösbar in
Aufnahmerohre eingesteckt sind, die durch einen Boden
einer Auffangwanne geführt und mit diesem fest verbunden sind.

In Ausgestaltung der Erfindung schließen die beiden
Aufnahmerohre die Rohrstücke einer T-förmig verzweigten Zufuhrleitung ab, die an die Druckseite einer
Pumpe angeschlossen ist. An den Innenwänden der Aufnahmerohre ist jeweils eine Dichtung als O-Ring oder
Manschette angebracht, in die der zugehörige Zufuhrstutzen der Staubadwanne eingeschoben ist.

HOECHST AKTIENGESELLSCHAFT
KALLE Niederlassung der Hoechst AG

- 6 -

Die zweckmäßige Weiterbildung der Erfindung ergibt
sich aus den Merkmalen der Patentansprüche 4 bis 10.

Mit der Erfindung werden die Vorteile erzielt, daß die
Entwicklungsvorrichtung ohne Sprührohre konstruiert
ist, wobei das zwischen Ein- und Auslaufrakel aufgestaute Entwicklerbad von unten durch die Staurinne der
Staubadwanne turbulenzfrei eingespeist wird und nach
dem Abschalten durch die gleiche Leitung über die
Pumpe zurück in den Vorratsbehälter läuft. Das Entwicklerbad wird zwischen der Ein- und Auslaufrakel
aufgestaut und der überschüssige Entwickler läuft über
die Seitenbegrenzungen in die Auffangwanne und von
dieser in den Vorratsbehälter ab, so daß es zu einer
laufenden Entwicklererneuerung kommt. Wird von der Abdeckung der Staubadwanne abgesehen, die kaum verschmutzt, so müssen zum Reinigen nur noch drei Teile,
die alle in Führungen bzw. Rohrstutzen mit Dichtungen
eingesteckt sind, herausgenommen werden. Dabei sind
für diese Arbeiten keine Werkzeuge erforderlich.

Die Erfindung wird im folgenden anhand eines zeichnerisch dargestellten Ausführungsbeispiels näher erläutert.

Es zeigen:

Fig. 1    einen schematischen Schnitt durch eine Vorrichtung nach der Erfindung mit Bürstwalzen
          zum Entwickeln von Negativdruckplatten,

HOECHST AKTIENGESELLSCHAFT
KALLE Niederlassung der Hoechst AG

- 7 -

Fig. 2    einen schematischen Schnitt ähnlich zu Fig. 1
          durch eine Vorrichtung nach der Erfindung,
          die keine Bürstwalzen aufweist und zum Bearbeiten von Positivdruckplatten geeignet ist,
          und

Fig. 3    eine schematische Draufsicht auf die Vorrichtung nach der Erfindung, wobei die Abdeckung,
          das Einlauf- und das Auslaufwalzenpaar aus
          Gründen der besseren Übersichtlichkeit nicht
          eingezeichnet sind.

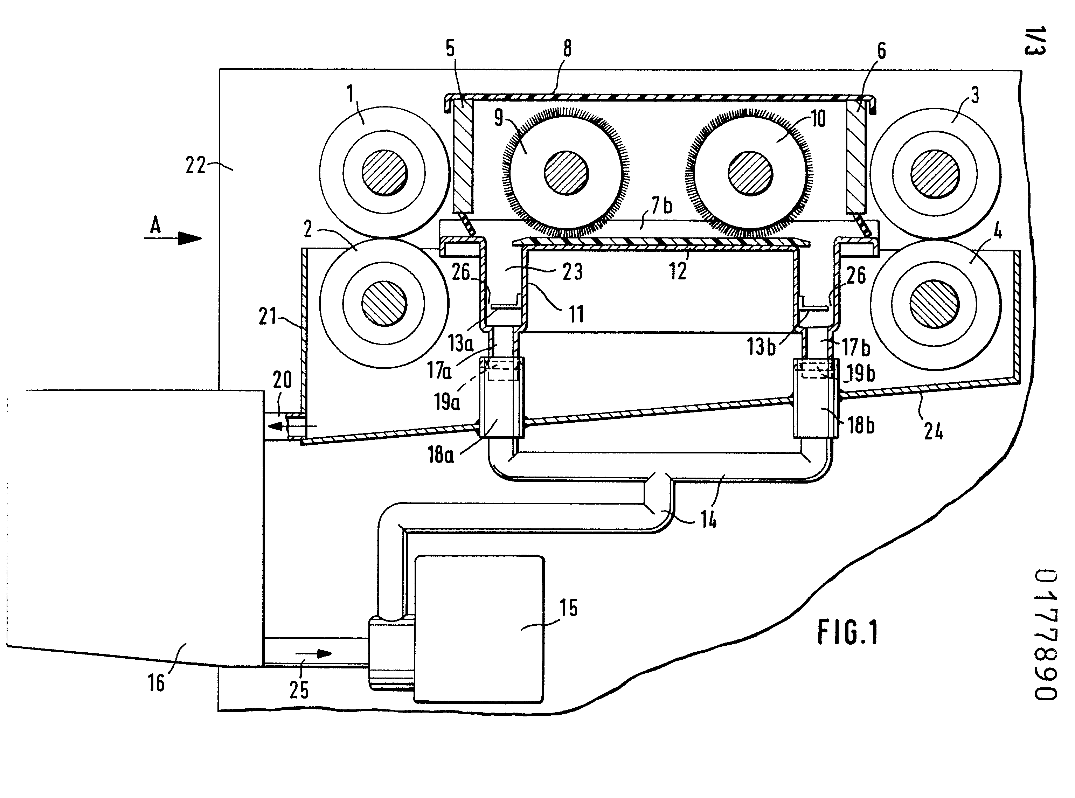

Die in Fig. 1 schematisch dargestellte Vorrichtung
weist ein Einlaufwalzenpaar und ein Auslaufwalzenpaar
auf, die zum horizontalen Transport von plattenförmigen Materialien wie Druckplatten in Durchlaufrichtung
A mit ihren Achsen waagerecht angeordnet sind. Von
jedem Walzenpaar ist eine untere Einlaufwalze 2 und
eine untere Auslaufwalze 4 in Seitenschilden 22 gelagert, zwischen denen eine Auffangwanne 21 angeordnet
ist, deren Seitenwände im Bereich der Achsschenkel
der Walzen 2,4 ausgespart sind. Eine obere Einlaufwalze 1 und eine obere Auslaufwalze 3 sind in Seitenschilden 22 der Vorrichtung gelagert. Das Einlauf- und
das Auslaufwalzenpaar befinden sich vor dem Eintritt
und nach dem Austritt einer Staubadwanne 11, gesehen
in Durchlaufrichtung A, und innerhalb der Auffangwanne
21, welche die Staubadwanne 11 umgibt. Die Staubadwanne 11 besteht aus einem Boden, der einen Plattenführungstisch 12 und eine um den Plattenführungstisch
umlaufende, mit diesem bzw. mit dem Boden integrierte
Staurinne 23 umfaßt. Der Plattenführungstisch 12 kann

HOECHST AKTIENGESELLSCHAFT
KALLE Niederlassung der Hoechst AG

- 8 -

beispielsweise ein auf dem Boden aufgeklebtes, geriffeltes PVC-Material sein, dessen Vorder- und Hinterkante abgeschrägt sind. Die Staurinne 23 umschließt rechteckförmig den Plattenführungstisch 12 und besitzt eingangs- und ausgangsseitig je einen Zufuhrstutzen 17a bzw. 17b für die Flüssigkeit. Die Zufuhrstutzen 17a und 17b erstrecken sich nach unten und sind lösbar in Aufnahmerohre 18a und 18b eingesteckt, die durch einen Boden 24 der Auffangwanne 21 geführt und mit diesem fest verbunden sind, beispielsweise verschweißt oder verklebt.

Die eingangsseitige sowie die ausgangsseitige Seitenwand der Staurinne 23 sind jeweils horizontal abgewinkelt und bilden die Auflageflächen des Bodens für eine vordere Staubadrakel 5 und eine hintere Staubadrakel 6. Die Auflageflächen des Bodens fluchten in Durchlaufrichtung A mit der Oberfläche des Plattenführungstisches 12.

An den Innenwänden der Aufnahmerohre 18a und 18b ist jeweils eine Dichtung 19a und 19b angebracht, in die der zugehörige Zufuhrstutzen 17a und 17b der Staubadwanne 11 eingeschoben ist. Bei den Dichtungen handelt es sich beispielsweise um O-Ringe oder Manschetten, die mit den Innenwänden der Aufnahmerohre verklebt oder in Paßsitzen eingepaßt sind, die in die Innenwände versenkt sind. Die Staubadwanne 11 aus dem Boden mit dem Plattenführungstisch 12, den beiden seitlichen Begrenzungswänden und je einem eingangs- und ausgangs-

HOECHST AKTIENGESELLSCHAFT
KALLE Niederlassung der Hoechst AG

- 9 -

seitig angeordneten Stauelement in Gestalt der Staubadrakeln 5 und 6 kann ohne Verwendung von Werkzeugen
aus ihrer Steckverbindung mit den Aufnahmerohren 18a
und 18b gelöst werden. Die beiden Aufnahmerohre 18a
und 18b schließen die Rohrstücke einer T-förmig verzweigten Zufuhrleitung 14 für die Entwicklerflüssigkeit ab, die an die Druckseite einer Pumpe 15 angeschlossen ist, die sich außerhalb und unterhalb der
Auffangwanne 21 befindet. Die Ansaugseite der Pumpe 15
ist über eine Leitung 25 mit einem Tank 16 als Vorratsbehälter für die Entwicklerflüssigkeit verbunden.
Die Zufuhr und der Abfluß der Entwicklerflüssigkeit zu
und aus der Staubadwanne 11 erfolgt jeweils über die
Zufuhrstutzen 17a,17b und die Zufuhrleitung 14 sowie
über die Leitung 25 von bzw. zu dem Tank 16. Der Tank
16 bildet über die Leitung 25 und die Zufuhrleitung 14
ein kommunizierendes Gefäß mit der Staubadwanne 11.
Der Tank ist des weiteren über einen Tankzulauf 20 mit
der tiefsten Stelle des Bodens 24 der Auffangwanne 21
verbunden. Der Boden 24 der Auffangwanne 21 ist zur
Horizontalen geneigt und steigt in Richtung der Auslaufseite der Druckplatten an.

In der Staurinne 23 befinden sich oberhalb der Eintrittsöffnungen der Zufuhrstutzen 17a und 17b Prallbleche 13a und 13b, die bis auf einen Spalt 26 den
Querschnitt der Staurinne 23 ausfüllen. Durch diese
Prallbleche 13a und 13b wird sichergestellt, daß in
der in die Staubadwanne 11 einströmenden Entwicklerflüssigkeit keine Turbulenzen auftreten, die zu einer unerwünschten streifenförmigen Aufentwicklung der Druckplatten Anlaß sein können.

Die Staubadwanne 11 ist von einer Abdeckung 8 abgeschlossen, die beispielsweise aus Kunststoff gefertigt ist und die, ohne an einer Stelle befestigt zu sein, auf den eingangs- und ausgangsseitig angeordneten Staubadrakeln 5 und 6 und auf den seitlichen Begrenzungswänden der Staubadwanne 11 aufliegt. In Fig. 1 sind des weiteren im Inneren der Staubadwanne 11 zwei Bürstwalzen 9 und 10 angeordnet, deren Bürsten in Kontakt mit der Oberfläche des Plattenführungstisches 12 stehen. Solche Bürstwalzen sind im allgemeinen für die Entwicklung von Negativdruckplatten erforderlich, da die Negativdruckplatten zum Teil Bindemittel enthalten, die die Entwicklerflüssigkeit nicht lösen kann und die daher durch die Bürstwalzen mechanisch entfernt werden müssen. Bei Negativdruckplatten neuerer Entwicklung sind auch die Bindemittel in der Entwicklerflüssigkeit löslich, so daß dann auf Bürstwalzen verzichtet werden kann.

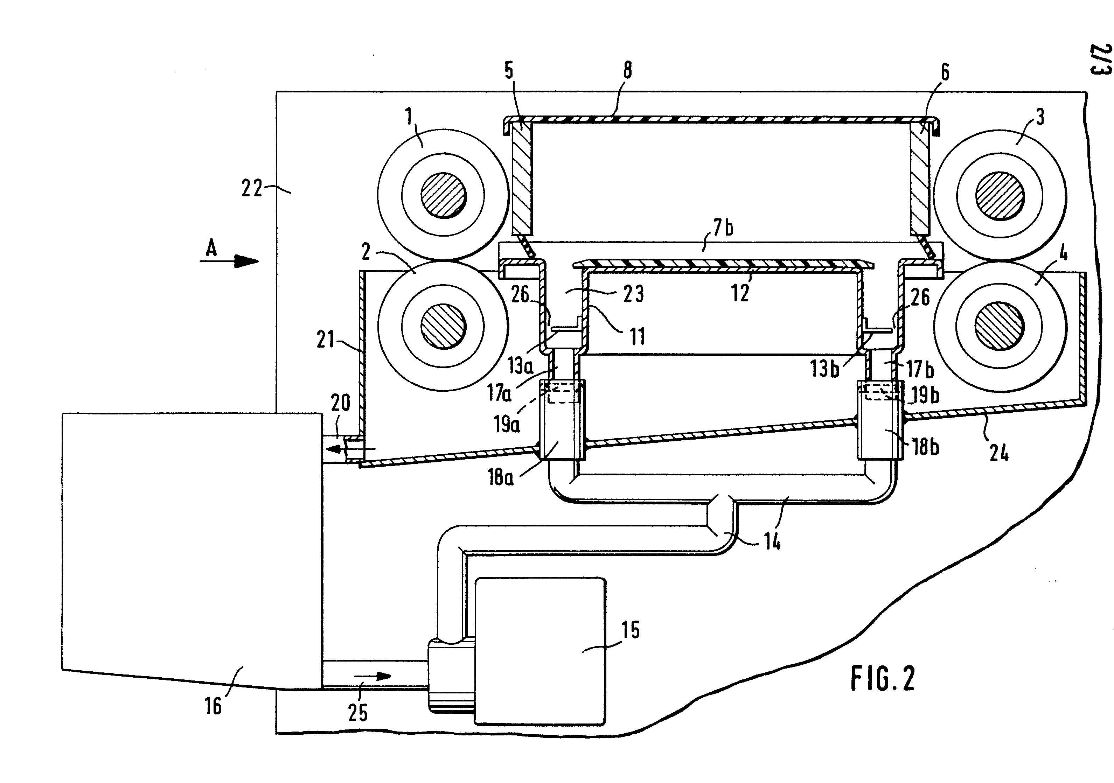

Die in Fig. 2 schematisch in Schnittansicht dargestellte Ausführungsform der Entwicklungsvorrichtung ist für die Entwicklung von Positivdruckplatten geeignet. Diese Ausführungsform ist, bis auf die fehlenden Bürstwalzen, identisch mit der Ausführungsform nach Fig. 1, so daß die einzelnen Bauteile und Baugruppen dieser Ausführungsform nicht nochmals beschrieben werden. Da für Positivdruckplatten andere Bindemittel als

HOECHST AKTIENGESELLSCHAFT
KALLE Niederlassung der Hoechst AG

- 11 -

für Negativdruckplatten verwendet werden und diese
Bindemittel weitgehend von der Entwicklerflüssigkeit
gelöst werden, entfällt ein Bürsten der Positivdruckplatten und somit auch die Bürstwalzen.

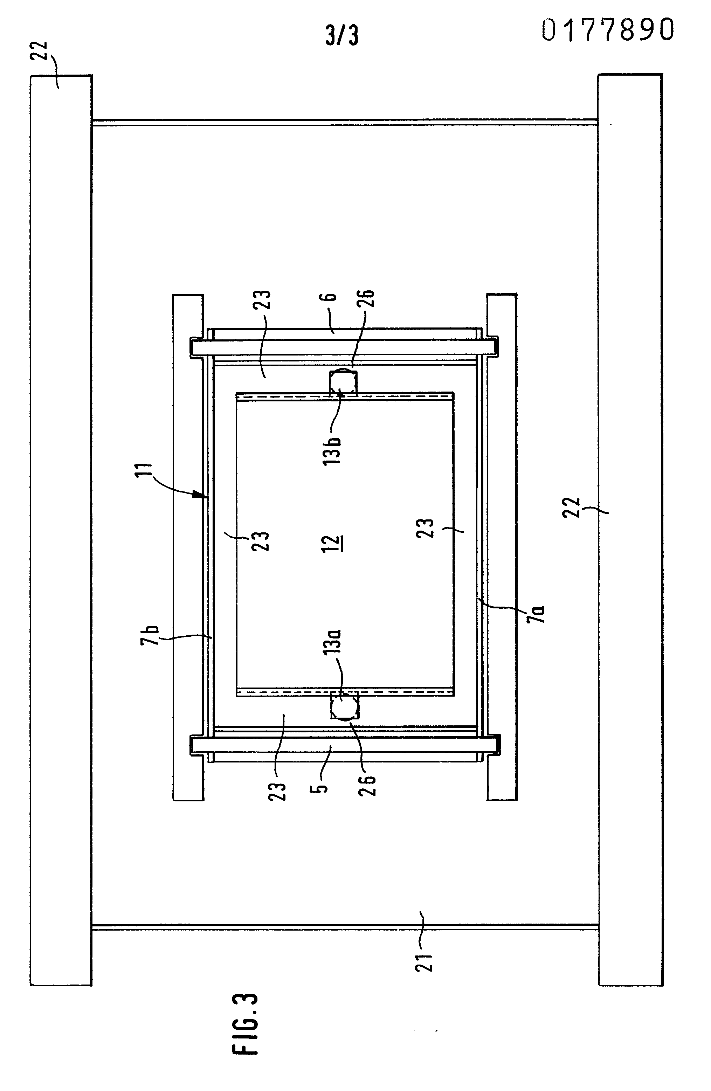

Fig. 3 zeigt eine schematische Draufsicht auf die Vorrichtung nach Fig. 1 bzw. Fig. 2, wobei die Abdeckung,
das Einlauf- und das Auslaufwalzenpaar aus Gründen der
besseren Übersichtlichkeit weggelassen sind. Die Staubadwanne 11 weist Seitenbegrenzungen 7a und 7b auf,
die parallel zur Durchlaufrichtung A der Druckplatten
ausgerichtet sind. Diese Seitenbegrenzungen 7a und 7b
begrenzen die um den Plattenführungstisch 12 umlaufende Staurinne 23 und weisen einen Spalt gegenüber
den Seitenwänden der Staubadwanne 11 auf. Durch diesen
Spalt kann die überschüssige Entwicklerflüssigkeit,
welche die Höhe der Seitenbegrenzungen 7a und 7b übersteigt, in die Auffangwanne 21 abfließen. Aus Fig. 3
ist ersichtlich, daß die vordere und die hintere Staubadrakel 5 und 6 in den Seitenwänden bzw. den seitlichen Begrenzungswänden der Staubadwanne 11 eingesetzt
sind. Des weiteren sind die Prallbleche 13a und 13b
oberhalb der Zutrittsöffnungen der Zufuhrstutzen 17a
und 17b dargestellt.

Zur Reinigung der Vorrichtung werden drei Teile abgehoben, nämlich die Abdeckung 8, die Staubadrakeln 5
und 6 und die Staubadwanne 11. Diese Teile können ohne
Verwendung von Werkzeugen entfernt werden. Nach dem
Abheben der Staubadwanne 11 sind die untere Einlauf-

HOECHST AKTIENGESELLSCHAFT
KALLE  Niederlassung der Hoechst AG

- 12 -

walze 2 und die untere Auslaufwalze 4 sowie der Boden 24 der Auffangwanne 21 für Reinigungsarbeiten frei zugänglich.

---

0177890

## Patentansprüche

1. Vorrichtung zum Behandeln von Druckplatten mit einer Flüssigkeit, in der die Druckplatten horizontal durch eine Staubadwanne, bestehend aus einem Boden, zwei seitlichen Begrenzungswänden und je einem eingangs- und ausgangsseitig angeordneten Stauelement, hindurchgeführt werden, dadurch gekennzeichnet, daß der Boden der Staubadwanne (11) einen Plattenführungstisch (12) und eine um den Plattenführungstisch umlaufende, mit diesem integrierte Staurinne (23) umfaßt, daß in der Staurinne (23) eingangs- und ausgangsseitig je ein Zufuhrstutzen (17a,17b) für die Flüssigkeit angeordnet ist und daß die beiden Zufuhrstutzen (17a,17b) lösbar in Aufnahmerohre (18a,18b) eingesteckt sind, die durch einen Boden (24) einer Auffangwanne (21) geführt und mit diesem fest verbunden sind.

2. Vorrichtung nach Anspruch 1, dadurch gekennzeichnet, daß die beiden Aufnahmerohre (18a,18b) die Rohrstücke einer T-förmig verzweigten Zufuhrleitung (14) abschließen, die an die Druckseite einer Pumpe (15) angeschlossen ist.

3. Vorrichtung nach den Ansprüchen 1 und 2, dadurch gekennzeichnet, daß an den Innenwänden der Aufnahmerohre (18a,18b) jeweils eine Dichtung (19a,19b) als 0-Ring oder Manschette angebracht ist, in die der zugehörige Zufuhrstutzen (17a,17b) der Staubadwanne (11) eingeschoben ist.

4. Vorrichtung nach Anspruch 1, dadurch gekennzeichnet, daß der Boden (24) der Auffangwanne (21) zur Horizontalen geneigt ist, wobei die tiefste Stelle des Bodens (24) über einen Tankzulauf (20) mit einem Tank (16) als Vorratsbehälter für die Flüssigkeit verbunden ist und daß der Tank (16) über eine unterhalb des Tankzulaufs (20) liegende Leitung (25) an die Ansaugseite der Pumpe (15) angeschlossen ist.

5. Vorrichtung nach Anspruch 4, dadurch gekennzeichnet, daß der Boden (24) der Auffangwanne (21) in Richtung der Auslaufseite der Druckplatten ansteigt.

6. Vorrichtung nach Anspruch 1, dadurch gekennzeichnet, daß in der Staurinne (23) oberhalb der Eintrittsöffnungen der Zufuhrstutzen (17a,17b) Prallbleche (13a,13b) angeordnet sind, die bis auf einen Spalt (26) den Querschnitt der Staurinne (23) ausfüllen.

7. Vorrichtung nach Anspruch 4, dadurch gekennzeichnet, daß die Auffangwanne (21) die Staubadwanne (11) umgibt und daß in zur Durchlaufrichtung (A) parallelen Seitenschilden (22,22) der Vorrichtung die untere Einlaufwalze (2) und die untere Auslaufwalze (4) gelagert sind.

8. Vorrichtung nach Anspruch 1, dadurch gekennzeichnet, daß die Staubadwanne (11) von einer Abdeckung (8) abgeschlossen ist, die, ohne an einer Stelle befestigt zu sein, auf der eingangs- und ausgangsseitigen Stau-

FIG.1

0177890

FIG.2

FIG.3